# EUROPÄISCHE PATENTANMELDUNG

(11) **EP 3 644 070 A1**
(43) Veröffentlichungstag der Anmeldung: **29.04.2020**
(21) Anmeldenummer: 19205312.2
(22) Anmeldetag: 25.10.2019
(51) Int. Cl.: G01R 19/165, G01R 22/06, G01R 31/378, G01R 31/3835, G01R 31/385

(54) **VORRICHTUNG MIT EINER FUNKKOMMUNIKATIONSEINHEIT UND EINER BATTERIE ZUR ELEKTRISCHEN ENERGIEVERSORGUNG ZUMINDEST DER FUNKKOMMUNIKATIONSEINHEIT UND VERFAHREN ZUR EINSTELLUNG EINER SENDELEISTUNG DER FUNKKOMMUNIKATIONSEINHEIT**

(30) Priorität: 25.10.2018 DE 102018126673
(71) Anmelder: QUNDIS GmbH, 99098 Erfurt (DE)
(72) Erfinder: LEIPOLD, Jörg, 99974 Mühlhausen (DE); BRANDL, Elena, 99092 Erfurt (DE)
(74) Vertreter: Liedtke & Partner Patentanwälte

(57) **Zusammenfassung**

Die Erfindung betrifft eine Vorrichtung (1) mit einer Funkkommunikationseinheit (2) und einer Batterie (3) zur elektrischen Energieversorgung zumindest der Funkkommunikationseinheit (2), umfassend eine Einheit (5) zur Ermittlung oder Prognose eines aktuellen Batterieladezustandes und zur Einstellung einer Sendeleistung der Funkkommunikationseinheit (2) in Abhängigkeit vom ermittelten oder prognostizierten Batterieladezustand und in Abhängigkeit von einer verbleibenden vorgegebenen Einsatzdauer der Vorrichtung (1).

Des Weiteren betrifft die Erfindung ein Verfahren zur Einstellung einer Sendeleistung einer Funkkommunikationseinheit (2) einer Vorrichtung (1).

## Beschreibung

Die Erfindung betrifft eine Vorrichtung mit einer Funkkommunikationseinheit und einer Batterie zur elektrischen Energieversorgung zumindest der Funkkommunikationseinheit und ein Verfahren zur Einstellung einer Sendeleistung einer Funkkommunikationseinheit einer Vorrichtung.

Aus dem Stand der Technik sind Verbrauchswerterfassungsgeräte und Verbrauchsdatensammler bekannt, die erfasste bzw. gesammelte Verbrauchswerte mittels einer Funkkommunikationseinheit senden. Diese Verbrauchswerterfassungsgeräte und Verbrauchsdatensammler weisen eine integrierte Batterie und beispielsweise zusätzlich einen Kondensator auf, welcher von der Batterie geladen wird, die elektrische Energie zwischenspeichert und an die Funkkommunikationseinheit zu deren elektrischer Energieversorgung abgibt.

Eine Sendeleistung der Funkkommunikationseinheit, ein Energieinhalt der Batterie und eine Kapazität des Kondensators sind aufeinander und auf eine vorgegebene Einsatzdauer des Verbrauchswerterfassungsgeräts oder Verbrauchsdatensammlers abgestimmt. Dabei erfolgen die Dimensionierung der Batterie und des Kondensators und die Einstellung der Sendeleistung so, dass der schlechteste Fall, d. h. ein vorgegebener maximaler Energieverbrauch, berücksichtigt wird, wobei auch bei Eintritt dieses schlechtesten Falls der Betrieb der Funkkommunikationseinheit bis zum Ende der Lebensdauer sichergestellt sein soll. Die auf diese Weise vorgenommene Einstellung der Sendeleistung gilt für die gesamte Einsatzdauer des Verbrauchswerterfassungsgeräts bzw. Verbrauchsdatensammlers.

Der Erfindung liegt die Aufgabe zu Grunde, eine gegenüber dem Stand der Technik verbesserte Vorrichtung mit einer Funkkommunikationseinheit und einer Batterie zur elektrischen Energieversorgung zumindest der Funkkommunikationseinheit und ein gegenüber dem Stand der Technik verbessertes Verfahren zur Einstellung einer Sendeleistung einer Funkkommunikationseinheit einer Vorrichtung anzugeben.

Die Aufgabe wird erfindungsgemäß gelöst durch eine Vorrichtung mit einer Funkkommunikationseinheit und einer Batterie zur elektrischen Energieversorgung zumindest der Funkkommunikationseinheit mit den Merkmalen des Anspruchs 1 und ein Verfahren zur Einstellung einer Sendeleistung einer Funkkommunikationseinheit einer Vorrichtung mit den Merkmalen des Anspruchs 9.

Vorteilhafte Ausgestaltungen der Erfindung sind Gegenstand der Unteransprüche.

Eine erfindungsgemäße Vorrichtung umfasst eine Funkkommunikationseinheit. Des Weiteren umfasst die Vorrichtung zur elektrischen Energieversorgung zumindest der Funkkommunikationseinheit eine Batterie. Zudem umfasst die Vorrichtung eine Einheit zur Ermittlung oder Prognose eines aktuellen Batterieladezustandes der Batterie und zur Einstellung einer Sendeleistung der Funkkommunikationseinheit in Abhängigkeit vom ermittelten oder prognostizierten Batterieladezustand und in Abhängigkeit von einer verbleibenden vorgegebenen Einsatzdauer der Vorrichtung. Die genannten Komponenten der Vorrichtung sind insbesondere in einem gemeinsamen Gehäuse der Vorrichtung angeordnet. Insbesondere die Batterie ist in der Vorrichtung integriert.

Die Batterie ist insbesondere als ein elektrochemischer Energiespeicher ausgebildet, welcher nicht wieder aufladbar ist. In anderen Ausführungsbeispielen könnte die Batterie beispielsweise auch als ein Akkumulator, d. h. als ein wieder aufladbarer elektrochemischer Energiespeicher, ausgebildet sein, jedoch wird, insbesondere bei vorgesehenen langen und insbesondere wartungsfreien Einsatzdauern bevorzugt, einen nicht wieder aufladbaren elektrochemischen Energiespeicher einzusetzen, insbesondere aufgrund einer Selbstentladeproblematik, welche bei wiederaufladbaren elektrochemischen Energiespeichern größer ist.

Die Funkkommunikationseinheit ist insbesondere ausschließlich von der Batterie mit elektrischer Energie versorgbar. Insbesondere ist die Funkkommunikationseinheit nicht von einer externen, insbesondere vorrichtungsexternen, Energiequelle mit elektrischer Energie versorgbar, d. h. es ist insbesondere keine Anschlussmöglichkeit zum Koppeln der Vorrichtung oder von deren Funkkommunikationseinheit mit einer anderen Energiequelle, beispielsweise mit einem Energieversorgungsnetz, vorhanden, und die Batterie ist der einzige Energiespeicher der Vorrichtung, insbesondere die einzige Energiequelle zur elektrischen Energieversorgung der Funkkommunikationseinheit.

Die Vorrichtung ist somit derart ausgebildet und eingerichtet, dass die Einheit während einer vorgegebenen Einsatzdauer der Vorrichtung mindestens einmal, insbesondere mehrfach, beispielsweise in vorgegebenen Zeitabständen, beispielsweise regelmäßig, insbesondere in vorgegebenen konstanten Zeitabständen, den aktuellen Batterieladezustand ermittelt oder prognostiziert und die Sendeleistung der Funkkommunikationseinheit in Abhängigkeit vom ermittelten oder prognostizierten und in Abhängigkeit von der jeweils verbleibenden vorgegebenen Einsatzdauer einstellt.

In einem erfindungsgemäßen Verfahren zur Einstellung der Sendeleistung der Funkkommunikationseinheit, insbesondere dieser Vorrichtung, und somit insbesondere in einem Verfahren zum Betrieb dieser Vorrichtung, wird während der vorgegebenen Einsatzdauer der Vorrichtung, insbesondere mittels der oben beschriebenen Einheit, mindestens einmal, insbesondere mehrfach, beispielsweise in vorgegebenen Zeitabständen, beispielsweise regelmäßig, insbesondere in vorgegebenen konstanten Zeitabständen, der aktuelle Batterieladezustand der Batterie ermittelt oder prognostiziert und die Sendeleistung der Funkkommunikationseinheit wird, insbesondere mittels der oben beschriebenen Einheit, in Abhängigkeit vom ermittelten oder prognostizierten Batterieladezustand und in Abhängigkeit von der jeweils verbleibenden vorgegebenen Einsatzdauer eingestellt.

Sowohl die erfindungsgemäße Vorrichtung als auch das erfindungsgemäße Verfahren ermöglichen eine Sicherstellung einer vorgesehenen Funkdatenübertragung bis zum Ende der vorgegebenen Einsatzdauer und eine optimale Anpassung der Sendeleistung an eine jeweils noch zur Verfügung stehende in der Batterie gespeicherte Energie.

Der Batterieladezustand kann beispielsweise durch eine Messung oder mehrere Messungen ermittelt werden, beispielsweise anhand eines Spannungseinbruchs bei einer hohen Strombelastung oder auf andere Weise.

In einer Ausführungsform umfasst die Vorrichtung zusätzlich einen Kondensator zur elektrischen Energieversorgung zumindest der Funkkommunikationseinheit. Die Vorrichtung umfasst in dieser Ausführungsform somit die Funkkommunikationseinheit und des Weiteren zur elektrischen Energieversorgung zumindest der Funkkommunikationseinheit die Batterie und den Kondensator. Zudem umfasst die Vorrichtung die Einheit zur Ermittlung oder Prognose des aktuellen Batterieladezustandes der Batterie und vorteilhafterweise einer aktuellen Kondensatorkapazität des Kondensators und zur Einstellung der Sendeleistung der Funckommunikationseinheit in Abhängigkeit vom ermittelten oder prognostizierten Batterieladezustand und vorteilhafterweise der ermittelten oder prognostizierten Kondensatorkapazität und in Abhängigkeit von der verbleibenden vorgegebenen Einsatzdauer der Vorrichtung. Die genannten Komponenten der Vorrichtung sind insbesondere im gemeinsamen Gehäuse der Vorrichtung angeordnet. Insbesondere die Batterie ist in der Vorrichtung integriert.

Die Batterie ist auch bei dieser Ausführungsform insbesondere als ein elektrochemischer Energiespeicher ausgebildet, welcher nicht wieder aufladbar ist. In anderen Ausführungsbeispielen könnte die Batterie beispielsweise auch als ein Akkumulator, d. h. als ein wieder aufladbarer elektrochemischer Energiespeicher, ausgebildet sein, jedoch wird, insbesondere bei vorgesehenen langen und insbesondere wartungsfreien Einsatzdauern bevorzugt, einen nicht wieder aufladbaren elektrochemischen Energiespeicher einzusetzen, insbesondere aufgrund einer Selbstentladeproblematik, welche bei wiederaufladbaren elektrochemischen Energiespeichern größer ist.

Die Funkkommunikationseinheit ist insbesondere ausschließlich von der Batterie oder ausschließlich von der Batterie und dem Kondensator mit elektrischer Energie versorgbar. Insbesondere ist die Funkkommunikationseinheit nicht von einer externen, insbesondere vorrichtungsexternen, Energiequelle mit elektrischer Energie versorgbar, d. h. es ist insbesondere keine Anschlussmöglichkeit zum Koppeln der Vorrichtung oder von deren Funkkommunikationseinheit mit einer anderen Energiequelle, beispielsweise mit einem Energieversorgungsnetz, vorhanden, und die Batterie und der Kondensator sind die einzigen Energiespeicher der Vorrichtung, insbesondere die einzigen Energiequellen zur elektrischen Energieversorgung der Funkkommunikationseinheit.

Die Vorrichtung ist somit derart ausgebildet und eingerichtet, dass die Einheit während einer vorgegebenen Einsatzdauer der Vorrichtung mindestens einmal, insbesondere mehrfach, beispielsweise in vorgegebenen Zeitabständen, beispielsweise regelmäßig, insbesondere in vorgegebenen konstanten Zeitabständen, den aktuellen Batterieladezustand und vorteilhafterweise die aktuelle Kondensatorkapazität ermittelt oder prognostiziert und die Sendeleistung der Funkkommunikationseinheit in Abhängigkeit vom ermittelten oder prognostizierten Batterieladezustand und vorteilhafterweise von der aktuellen Kondensatorkapazität und in Abhängigkeit von der jeweils verbleibenden vorgegebenen Einsatzdauer einstellt.

In einer Ausführungsform des Verfahrens wird während der vorgegebenen Einsatzdauer der Vorrichtung, insbesondere mittels der oben beschriebenen Einheit, mindestens einmal, insbesondere mehrfach, beispielsweise in vorgegebenen Zeitabständen, beispielsweise regelmäßig, insbesondere in vorgegebenen konstanten Zeitabständen, der aktuelle Batterieladezustand der Batterie und vorteilhafterweise die aktuelle Kondensatorkapazität des Kondensators ermittelt oder prognostiziert und die Sendeleistung der Funkkommunikationseinheit wird, insbesondere mittels der oben beschriebenen Einheit, in Abhängigkeit vom ermittelten oder prognostizierten Batterieladezustand und vorteilhafterweise von der ermittelten oder prognostizierten Kondensatorkapazität und in Abhängigkeit von der jeweils verbleibenden vorgegebenen Einsatzdauer eingestellt.

Sowohl diese Ausführungsform der Vorrichtung als auch diese Ausführungsform des Verfahrens ermöglichen auch bei einem zusätzlich zur Batterie vorhandenen Kondensator die Sicherstellung der vorgesehenen Funkdatenübertragung bis zum Ende der vorgegebenen Einsatzdauer und die optimale Anpassung der Sendeleistung an die jeweils noch zur Verfügung stehende in der Batterie gespeicherte Energie und vorteilhafterweise an die jeweils noch vorhandene Kapazität des Kondensators.

Der Batterieladezustand und vorteilhafterweise die Kondensatorkapazität können beispielsweise durch eine jeweilige Messung oder mehrere Messungen ermittelt werden, beispielsweise anhand eines jeweiligen Spannungseinbruchs bei einer hohen Strombelastung oder auf andere Weise.

Der Kondensator kann insbesondere als ein von der Batterie ladbarer oder geladener Zwischenspeicherkondensator zur Zwischenspeicherung elektrischer Energie zumindest für die Funkkommunikationseinheit ausgebildet sein, auch als Ladekondensator bezeichnet. Im Verfahren wird dieser als Zwischenspeicherkondensator ausgebildete Kondensator dann zweckmäßigerweise von der Batterie geladen, die elektrische Energie wird im Kondensator zwischengespeichert und zumindest die Funkkommunikationseinheit wird mit der zwischengespeicherten elektrischen Energie versorgt.

D. h. die Batterie ist die einzige elektrische Energiequelle zur elektrischen Energieversorgung zumindest der Funkkommunikationseinheit, wobei die Funkkommunikationseinheit beispielsweise nicht direkt von der Batterie mit elektrischer Energie versorgt wird, sondern, insbesondere wenn der Kondensator vorhanden ist, wird der Kondensator von der Batterie mit elektrischer Energie geladen, welche von der Batterie geliefert wird, speichert diese elektrische Energie zwischen und gibt dann diese von der Batterie gelieferte elektrische Energie an die Funkkommunikationseinheit ab. Es handelt sich somit insbesondere um eine batteriebetriebene Vorrichtung, insbesondere um eine ausschließlich batteriebetriebene Vorrichtung, wobei zumindest die Funkkommunikationseinheit direkt von der Batterie mit elektrischer Energie versorgt wird und/oder, insbesondere wenn der Kondensator vorhanden ist, vom Kondensator mit elektrischer Energie versorgt wird, welcher von der Batterie geladen wird. Insbesondere ein Funkstrom wird somit direkt von der Batterie und/oder vom als Ladekondensator ausgebildeten Kondensator gespeist, welcher von der Batterie geladen wird.

Der Kondensator wird beispielsweise verwendet, um eine zu hohe Spitzenbelastung der Batterie zu vermeiden, da dies beispielsweise die Batterie schädigen könnte. Beispielsweise wird der Kondensator insbesondere bei einem Einsatz hochohmiger Batterien verwendet.

Die Verwendung des Kondensators hat insbesondere den Vorteil, dass die Batterie den Kondensator langsam aufladen kann und der Kondensator die zwischengespeicherte elektrische Energie schnell an die Funkkommunikationseinheit abgeben kann, wenn sie von der Funkkommunikationseinheit benötigt wird. Die Funckommunikationseinheit sendet üblicherweise nicht durchgängig, sondern beispielsweise zu vorgegebenen Zeitpunkten und/oder in vorgegebenen Zeitabständen, benötigt dann jedoch für eine erforderliche Sendeleistung und für eine erforderliche Sendedauer in relativ kurzer Zeit, insbesondere für die Zeitspanne dieser Sendedauer, eine relativ hohe elektrische Energie, welche der Kondensator in dieser kurzen Zeit liefern kann.

Durch mehrfaches, beispielsweise regelmäßiges oder unregelmäßiges, Senden der Funkkommunikationseinheit wird der Kondensator somit entsprechend oft aufgeladen und entladen. Dies und eine zunehmende Alterung des Kondensators belasten dessen Kapazität, d. h. diese reduziert sich zunehmend, wodurch der Kondensator mit zunehmender Einsatzdauer der Vorrichtung von der Batterie zunehmend geringer geladen werden kann, d. h. zunehmend weniger elektrische Energie zwischenspeichern kann. Zudem ist die Kapazität des Kondensators beispielsweise auch temperaturabhängig. Dies kann zum Beispiel auch zu einer reduzierten Zwischenspeicherung der elektrischen Energie führen.

Somit kann sowohl der verbleibende Batterieladezustand als auch die verbleibende Kondensatorkapazität bei zunehmender Einsatzdauer der Vorrichtung zu gering sein, um das Senden mit einer am Anfang der Einsatzdauer vorgegebenen Sendeleistung sicherzustellen. Daher werden vorteilhafterweise mindestens einmal, insbesondere mehrfach, beispielsweise in vorgegebenen Zeitabständen, beispielsweise regelmäßig, insbesondere in vorgegebenen konstanten Zeitabständen, sowohl der aktuelle Batterieladezustand der Batterie als auch die aktuelle Kondensatorkapazität des Kondensators ermittelt oder prognostiziert und die Sendeleistung der Funkkommunikationseinheit wird in Abhängigkeit vom ermittelten oder prognostizierten Batterieladezustand und von der ermittelten oder prognostizierten Kondensatorkapazität und in Abhängigkeit von der jeweils verbleibenden vorgegebenen Einsatzdauer eingestellt, um den Sendebetrieb der Funkkommunikationseinheit, insbesondere die vorgesehene Funkdatenübertragung, bis zum Ende der vorgegebenen Einsatzdauer sicherzustellen und eine optimale Anpassung der Sendeleistung an die jeweils noch zur Verfügung stehende in der Batterie gespeicherte Energie und/oder an die jeweils noch vorhandene Kapazität des Kondensators zu erreichen.

Insbesondere aufgrund der oben beschriebenen Temperaturabhängigkeit der Kapazität des Kondensators umfasst die Vorrichtung in einer Ausführungsform zudem eine Temperaturermittlungseinheit zur Ermittlung der Umgebungstemperatur. Die Einheit ist dann vorteilhafterweise vorgesehen zur Einstellung der Sendeleistung der Funkkommunikationseinheit zusätzlich in Abhängigkeit von der ermittelten Umgebungstemperatur. Im Verfahren wird vorteilhafterweise zusätzlich die Umgebungstemperatur ermittelt, vorteilhafterweise dann, wenn auch der Batterieladezustand und vorteilhafterweise die Kondensatorkapazität ermittelt oder prognostiziert werden, und die Sendeleistung der Funkkommunikationseinheit zusätzlich in Abhängigkeit von der ermittelten Umgebungstemperatur eingestellt. Die Vorrichtung umfasst in dieser Ausführungsform somit die Funkkommunikationseinheit und des Weiteren zur elektrischen Energieversorgung zumindest der Funkkommunikationseinheit die Batterie und den Kondensator und zudem umfasst die Vorrichtung die Temperaturermittlungseinheit zur Ermittlung der Umgebungstemperatur. Zudem umfasst die Vorrichtung die Einheit zur Ermittlung oder Prognose des aktuellen Batterieladezustandes der Batterie und vorteilhafterweise der aktuellen Kondensatorkapazität des Kondensators und zur Einstellung der Sendeleistung der Funkkommunikationseinheit in Abhängigkeit vom ermittelten oder prognostizierten Batterieladezustand und vorteilhafterweise der ermittelten oder prognostizierten Kondensatorkapazität und in Abhängigkeit von der verbleibenden vorgegebenen Einsatzdauer der Vorrichtung und vorteilhafterweise in Abhängigkeit von der Umgebungstemperatur. Die Temperaturermittlungseinheit kann ein Bestandteil dieser Einheit sein.

Die genannten Komponenten der Vorrichtung sind insbesondere im gemeinsamen Gehäuse der Vorrichtung angeordnet. Insbesondere die Batterie ist in der Vorrichtung integriert.

Die Vorrichtung ist somit derart ausgebildet und eingerichtet, dass die Einheit während einer vorgegebenen Einsatzdauer der Vorrichtung mindestens einmal, insbesondere mehrfach, beispielsweise in vorgegebenen Zeitabständen, beispielsweise regelmäßig, insbesondere in vorgegebenen konstanten Zeitabständen, den aktuellen Batterieladezustand und vorteilhafterweise die aktuelle Kondensatorkapazität ermittelt oder prognostiziert und die Sendeleistung der Funkkommunikationseinheit in Abhängigkeit vom ermittelten oder prognostizierten Batterieladezustand und vorteilhafterweise von der aktuellen Kondensatorkapazität und in Abhängigkeit von der jeweils verbleibenden vorgegebenen Einsatzdauer und vorteilhafterweise zudem in Abhängigkeit von der ermittelten Umgebungstemperatur einstellt. Die Umgebungstemperatur wird hierbei vorteilhafterweise jeweils dann ermittelt, wenn auch der aktuelle Batterieladezustand und vorteilhafterweise die aktuelle Kondensatorkapazität ermittelt oder prognostiziert werden.

In einer Ausführungsform des Verfahrens wird somit während der vorgegebenen Einsatzdauer der Vorrichtung, insbesondere mittels der oben beschriebenen Einheit, mindestens einmal, insbesondere mehrfach, beispielsweise in vorgegebenen Zeitabständen, beispielsweise regelmäßig, insbesondere in vorgegebenen konstanten Zeitabständen, der aktuelle Batterieladezustand der Batterie und vorteilhafterweise die aktuelle Kondensatorkapazität des Kondensators ermittelt oder prognostiziert und vorteilhafterweise zusätzlich die aktuelle Umgebungstemperatur ermittelt, insbesondere mittels der Temperaturermittlungseinheit zur Ermittlung der Umgebungstemperatur, welche ein Bestandteil dieser Einheit sein kann, und die Sendeleistung der Funkkommunikationseinheit wird, insbesondere mittels der oben beschriebenen Einheit, in Abhängigkeit vom ermittelten oder prognostizierten Batterieladezustand und vorteilhafterweise von der ermittelten oder prognostizierten Kondensatorkapazität und in Abhängigkeit von der jeweils verbleibenden vorgegebenen Einsatzdauer und vorteilhafterweise zusätzlich in Abhängigkeit von der ermittelten Umgebungstemperatur eingestellt.

Sowohl diese Ausführungsform der Vorrichtung als auch diese Ausführungsform des Verfahrens ermöglichen die Sicherstellung der vorgesehenen Funkdatenübertragung bis zum Ende der vorgegebenen Einsatzdauer und die optimale Anpassung der Sendeleistung an die jeweils noch zur Verfügung stehende in der Batterie gespeicherte Energie und vorteilhafterweise an die jeweils noch vorhandene Kapazität des Kondensators, wobei vorteilhafterweise zudem die Umgebungstemperatur berücksichtigt wird.

Die Vorrichtung ist beispielsweise als eine Verbrauchswerterfassungseinheit ausgebildet, zum Beispiel als ein elektronischer Heizkostenverteiler, Wasserzähler, Wärmezähler, Stromzähler oder Gaszähler oder sie ist beispielsweise als ein Verbrauchsdatensammler ausgebildet. Ein solcher Verbrauchsdatensammler, auch als Datenkollektor bezeichnet, empfängt Verbrauchsdaten von mehreren Verbrauchswerterfassungseinheiten und sendet sie weiter, beispielsweise nach einer Zwischenspeicherung.

Derartige Verbrauchswerterfassungseinheiten oder Datensammler senden über die Funkkommunikationseinheit beispielsweise mehrmals täglich, mehrmals wöchentlich, mehrmals monatlich und/oder mehrmals jährlich Datentelegramme, die beispielsweise, abhängig von ihrem jeweiligen Inhalt, eine unterschiedliche Länge aufweisen. Die zum Senden erforderliche elektrische Energie bezieht die Funkkommunikationseinheit von der Batterie, insbesondere über den Kondensator, in welchem sie zwischengespeichert wird, d. h. auf die oben bereits beschriebene Weise.

Derartige Vorrichtungen weisen zudem eine lange, insbesondere wartungsfreie, vorgesehene Einsatzdauer auf, beispielsweise eine Einsatzdauer von mehreren Jahren, beispielsweise eine Einsatzdauer von 10 Jahren. Wie bereits beschrieben, ist mit zunehmender Einsatzdauer, beispielsweise nach mehreren Einsatzjahren, der Batterieladezustand der Batterie und somit eine Batteriespannung der Batterie und, wenn der Kondensator vorhanden ist, die Kondensatorkapazität des Kondensators, insbesondere des Zwischenspeicherkondensators, abgesunken. Bisher wird dies vor dem Einsatz der Vorrichtung, insbesondere bereits bei deren Auslegung, berücksichtigt, weswegen überdimensionierte teure Batterien und Kondensatoren verwendet werden und/oder eine reduzierte Sendeleistung eingestellt wird. Während der Einsatzdauer der Vorrichtung werden bisher keine Änderungen vorgenommen.

Bei dieser bisherigen Vorgehensweise steigt trotzdem das Risiko zum Ende der Einsatzdauer, dass lange Datentelegramme wegen Energiemangel, beispielsweise aufgrund eines zu niedrigen Batterieladezustands und/oder einer zu geringen Kondensatorkapazität und einer daraus resultierenden zu geringen elektrischen Energieversorgung der Funkkommunikationseinheit nicht gesendet werden können. Beispielsweise weist die Funkkommunikationseinheit, welche zum Beispiel als ein Funk-Transmitterbaustein ausgebildet ist, eine Spannungsüberwachung auf und bricht eine Funkübertragung bei einer zu geringen elektrischen Spannung ab. Abhängig von einer Formatklasse der Datentelegramme und einer Software in einem Empfänger können solche Datentelegramme dann nicht oder nur teilweise empfangen werden.

Durch die beschriebene Lösung werden diese Probleme vermieden, indem der Batterieladezustand oder, je nach Betrachtungsweise, Batterieentladezustand der Batterie und vorteilhafterweise die Kondensatorkapazität des Kondensators, wenn dieser vorhanden ist, vorteilhafterweise sowohl der Batterieladezustand als auch die Kondensatorkapazität, ermittelt oder prognostiziert, insbesondere geschätzt, werden, um die Sendeleistung entsprechend zu korrigieren. Vorteilhafterweise wird zudem die Umgebungstemperatur berücksichtigt, wie oben beschrieben, um die Sendeleistung entsprechend zu korrigieren. Durch die Einstellung einer etwas geringeren Sendeleistung bei oben genannten Bedingungen sinkt der elektrische Energiebedarf der Funkkommunikationseinheit deutlich, so dass ein Datentelegramm trotz schwacher Batterie, d. h. trotz geringem Batterieladezustand, und/oder trotz geringer Kondensatorkapazität noch vollständig gesendet werden kann. Ein Abbrechen der Funkaussendung würde in allen Fällen den Verlust der Daten am Empfänger bedeuten.

Die Aussendung mit geringerer Sendeleistung verhindert oder erschwert deutlich den Empfang nur bei Vorrichtungen, die schon vorher beim Empfänger einen niedrigen Pegel aufwiesen, da dann der Pegel aufgrund der Reduzierung der Sendeleistung zu stark abfallen könnte. Die jeweilige Vorrichtung wird jedoch zweckmäßigerweise derart angeordnet, dass ein ausreichender Pegel, insbesondere mit ausreichenden Reserven, beim Empfänger vorhanden ist, so dass ein Absenken der Sendeleistung im Laufe der Einsatzdauer der Vorrichtung unproblematisch ist.

Durch die beschriebene Lösung wird somit eine höhere Produktqualität erreicht. Des Weiteren kann die Überdimensionierung der Batterie und/oder des Kondensators vermieden werden, wodurch eine entsprechende Kostenreduzierung erreicht wird.

Bei der beschriebenen Lösung werden insbesondere auch während der Einsatzdauer zufällig auftretende Faktoren berücksichtigt, da der Batterieladezustand und, wenn der Kondensator vorhanden ist, vorteilhafterweise auch die Kondensatorkapazität während der Einsatzdauer ermittelt oder prognostiziert wird, so dass auch bei solchen den Energieverbrauch erhöhenden und/oder die Kondensatorkapazität überdurchschnittlich reduzierenden zufälligen Faktoren das Senden der Datentelegramme bis zum Ende der Einsatzdauer sichergestellt ist, indem die Sendeleistung entsprechend angepasst wird.

Die beschriebene Lösung ermöglicht es zudem, am Beginn der Einsatzdauer der Vorrichtung eine größere Sendeleistung zu verwenden, um eine bessere Inbetriebnahme und Installation der Vorrichtung und beispielsweise eine bessere Integration in ein Funknetzwerk zu ermöglichen. Danach kann die Sendeleistung in Abhängigkeit von der dann noch verbleibenden Einsatzdauer und in Abhängigkeit vom dann noch verbleibenden Batterieladezustand und, wenn der Kondensator vorhanden ist, vorteilhafterweise in Abhängigkeit von der dann noch verbleibenden Kondensatorkapazität und vorteilhafterweise zudem auch in Abhängigkeit von der Umgebungstemperatur angepasst werden.

Wie oben bereits beschrieben, wird während der vorgegebenen Einsatzdauer der Vorrichtung, insbesondere mittels der oben beschriebenen Einheit, mindestens einmal, insbesondere mehrfach, beispielsweise in vorgegebenen Zeitabständen, beispielsweise regelmäßig, insbesondere in vorgegebenen konstanten Zeitabständen, der aktuelle Batterieladezustand der Batterie und vorteilhafterweise die aktuelle Kondensatorkapazität des Kondensators ermittelt oder prognostiziert und beispielsweise die aktuelle Umgebungstemperatur ermittelt. Dies erfolgt beispielsweise periodisch, zum Beispiel mit einer Periode von 1/100 Stunde oder jede Minute oder alle 256 s. Es sind beispielsweise auch größere Zeitabstände möglich, zum Beispiel einmal pro Tag oder einmal pro Woche oder einmal pro Monat. Vorteilhafterweise erfolgt dies nicht während eines Sendens der Datentelegramme, sondern dann, wenn nicht gesendet wird. Dadurch wird insbesondere vermieden, dass die Ermittlung des Batterieladezustands und beispielsweise der Kondensatorkapazität und/oder der Umgebungstemperatur durch das Senden verfälscht wird. Zudem wird dadurch vermieden, dass die Sendeleistung während des Sendens, d. h. während eines jeweiligen Sendevorgangs, zum Beispiel während des Sendens eines Datentelegramms, angepasst wird. Die Sendeleistung bleibt somit vorteilhafterweise während des Sendens stets konstant. Die Anpassung der Sendeleistung erfolgt somit vorteilhafterweise nur, wenn nicht gesendet wird, d. h. die Sendeleistung wird für nachfolgende Sendevorgänge angepasst und diese jeweils angepasste Sendeleistung wird dann für einen oder mehrere nachfolgende Sendevorgänge verwendet. Insbesondere die Batteriespannungsmessung erfolgt beispielsweise durch einen Mikrocontroller der Vorrichtung.

Besonders vorteilhaft ist die beschriebene Lösung beispielsweise bei tiefen Umgebungstemperaturen, da dann eine Leerlaufspannung der Batterie absinkt und ein Innenwiderstand zunimmt. Der Effekt wird stärker, je weiter die Batterie entladen ist. Erwärmt sich die Umgebung wieder, erholt sich auch die Batterie und kann auch mehr Strom abgeben. Durch die beschriebene Lösung kann die Sendeleistung an diese Bedingungen angepasst werden und somit über die jeweils noch verbleibende vorgegebene Einsatzdauer optimiert werden.

Die beschriebene Lösung ist insbesondere auch dahingehend besonders vorteilhaft, dass dem Einsatz einer solchen Vorrichtung, für welchen die Batterie ausgelegt ist, oft noch eine Lagerungszeit der Vorrichtung, beispielsweise bei einem Hersteller und bei einem Kunden, vorausgeht, deren Dauer nicht exakt vorhersagbar ist. Diese Lagerung der Vorrichtung wirkt sich ebenfalls bereits auf den Batterieladezustand der Batterie aus. Beispielsweise könnte dann der Fall eintreten, dass bei einer zu langen Lagerung der Vorrichtung die Batterie dann während des anschließenden Einsatzes der Vorrichtung bereits entladen ist, bevor die vorgegebene Einsatzdauer erreicht ist. Dies wird mittels der beschriebenen Lösung vermieden, da die Sendeleistung auf die oben beschriebene Weise angepasst wird.

Ausführungsbeispiele der Erfindung werden im Folgenden anhand einer Zeichnung näher erläutert.

Darin zeigt:

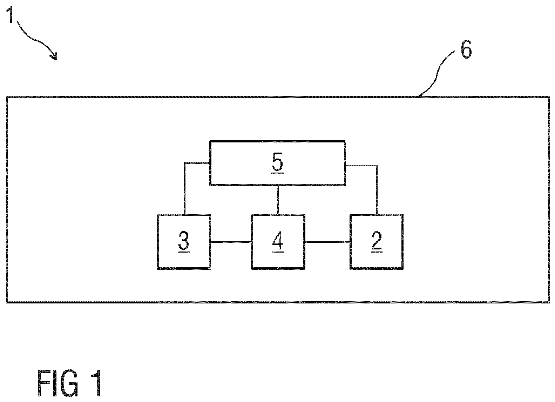

- Figur 1: schematisch eine Vorrichtung, umfassend eine Funkkommunikationseinheit und eine Batterie sowie einen Kondensator zur elektrischen Energieversorgung zumindest der Funkkommunikationseinheit.

**Figur** 1 zeigt eine schematische Darstellung einer Vorrichtung 1, welche beispielsweise als eine Verbrauchswerterfassungseinheit oder als ein Verbrauchsdatensammler, auch als Datenkollektor bezeichnet, ausgebildet ist. Beispielsweise ist die Vorrichtung 1 als ein elektronischer Heizkostenverteiler, Wasserzähler, Wärmezähler, Stromzähler oder Gaszähler ausgebildet.

Die Vorrichtung 1 umfasst eine Funkkommunikationseinheit 2, eine Batterie 3 zur elektrischen Energieversorgung zumindest der Funkkommunikationseinheit 2 und im dargestellten Beispiel einen als ein Zwischenspeicherkondensator ausgebildeten Kondensator 4 zur Zwischenspeicherung von der Batterie 3 gelieferter elektrischer Energie zumindest für die Funkkommunikationseinheit 2. Dieser Zwischenspeicherkondensator wird auch als Ladekondensator bezeichnet.

Zumindest die Funkkommunikationseinheit 2 wird ausschließlich mittels elektrischer Energie der Batterie 3 betrieben, welche im Kondensator 4 zwischengespeichert wird, d. h. die Batterie 3 lädt den Kondensator 4, welcher die elektrische Energie zwischenspeichert und an die Funkkommunikationseinheit 2 abgibt, wenn die elektrische Energie benötigt wird. Es steht somit insbesondere keine externe, insbesondere keine vorrichtungsexterne, elektrische Energiequelle zur Energieversorgung der Funkkommunikationseinheit 2 zur Verfügung. Eine solche anderweitige elektrische Energieversorgung ist auch nicht vorgesehen, d. h. es ist beispielsweise auch kein Anschluss an ein elektrisches Energieversorgungsnetz vorgesehen. Es handelt sich somit insbesondere um eine batteriebetriebene Vorrichtung 1, insbesondere um eine ausschließlich batteriebetriebene Vorrichtung 1.

Derartige Vorrichtungen 1, insbesondere Messgeräte und/oder andere Geräte eines so genannten Smart Metering Systems, d. h. eines Verbrauchsdatenerfassungssystems, welches insbesondere so genannte intelligente Geräte, insbesondere Verbrauchswerterfassungseinheiten, aufweist, funken beispielsweise mehrmals am Tag Datentelegramme. Diese Datentelegramme können, insbesondere abhängig von ihrem Inhalt, eine unterschiedliche Länge aufweisen. Ein Funkstrom wird von der Batterie 3 gespeist, entweder direkt oder, wie im dargestellten Beispiel, über den Kondensator 4, d. h. Die Funkkommunikationseinheit 2 wird entweder direkt oder über den Kondensator 4 von der Batterie 3 mit elektrischer Energie versorgt.

Nach mehreren Betriebsjahren, d. h nach mehreren Einsatzjahren der Vorrichtung 1, und beispielsweise zudem in Abhängigkeit von der Umgebungstemperatur, sinken sowohl ein Batterieladezustand und damit eine Batteriespannung der Batterie 3 als auch eine Kondensatorkapazität des Kondensators 4, die Kondensatorkapazität natürlich nur, wenn der Kondensator 4 vorhanden ist, wie im hier dargestellten Beispiel. Diese Verschlechterung wird bei aus dem Stand der Technik bekannten Geräten bei deren Auslegung berücksichtigt, weswegen überdimensionierte teure Batterien 3 und/oder Kondensatoren 4 zum Einsatz kommen und/oder generell eine reduzierte Sendeleistung eingestellt wird.

Trotzdem steigt das Risiko zum Ende einer vorgesehenen Einsatzdauer, dass lange Datentelegramme wegen Energiemangel und/oder einer niedrigen Restkondensatorkapazität nicht gefunkt werden können, d. h. nicht gesendet werden können. Beispielsweise haben als Funk-Transmitterbausteine ausgebildete Funkkommunikationseinheiten 2 eine Spannungsüberwachung und brechen eine Funkübertragung ab, wenn die Spannung zu niedrig wird. Abhängig von einer Formatklasse der Datentelegramme und einer Software eines Empfängers können solche Datentelegramme nicht oder nur teilweise empfangen werden.

Daher ist bei der hier beschriebenen Vorrichtung 1 vorgesehen, einen verbliebenen Batterieladezustand oder, je nach Sichtweise, Batterieentladezustand der Batterie 3 und/oder eine verbliebene Kondensatorkapazität des Kondensators 4 zu messen oder abzuschätzen, d. h. insbesondere zu ermitteln oder zu prognostizieren, um eine Sendeleistung entsprechend zu korrigieren. Hierzu weist die Vorrichtung 1 eine Einheit 5 zur Ermittlung oder Prognose des aktuellen Batterieladezustandes und/oder der aktuellen Kondensatorkapazität und zur Einstellung der Sendeleistung der Funkkommunikationseinheit 2 in Abhängigkeit vom ermittelten oder prognostizierten Batterieladezustand und/oder der ermittelten oder prognostizierten Kondensatorkapazität und in Abhängigkeit von einer verbleibenden vorgegebenen Einsatzdauer der Vorrichtung 1 auf. Diese Einheit 5 ist vorteilhafterweise, zusammen mit den anderen hier beschriebenen und in Figur 1 gezeigten Komponenten der Vorrichtung 1, d. h. zusammen mit der Funkkommunikationseinheit 2, der Batterie 3 und dem Kondensator 4, in einem gemeinsamen Gehäuse 6 der Vorrichtung 1 angeordnet. Vorteilhafterweise weist die Vorrichtung 1 zudem eine Temperaturermittlungseinheit zur Ermittlung der Umgebungstemperatur auf, welche beispielsweise ein Bestandteil der Einheit 5 ist. Auf diese Weise kann zusätzlich die aktuelle Umgebungstemperatur ermittelt und bei der Einstellung der Sendeleistung berücksichtigt werden.

In einem Verfahren zum Betrieb der Vorrichtung 1, insbesondere zur Einstellung der Sendeleistung der Funkkommunikationseinheit 2 wird somit während der vorgegebenen Einsatzdauer der Vorrichtung 1 mindestens einmal, insbesondere mehrfach, beispielsweise in vorgegebenen Zeitabständen, beispielsweise regelmäßig, insbesondere in vorgegebenen konstanten Zeitabständen, der aktuelle Batterieladezustand der Batterie 3 und/oder die aktuelle Kondensatorkapazität des Kondensators 4 ermittelt oder prognostiziert und/oder vorteilhafterweise zudem die aktuelle Umgebungstemperatur ermittelt und die Sendeleistung der Funkkommunikationseinheit 2 wird in Abhängigkeit vom ermittelten oder prognostizierten Batterieladezustand und/oder von der ermittelten oder prognostizierten Kondensatorkapazität und/oder vorteilhafterweise von der ermittelten aktuellen Umgebungstemperatur und in Abhängigkeit von der jeweils verbleibenden vorgegebenen Einsatzdauer eingestellt.

Der Batterieladezustand und, falls der Kondensator 4 vorhanden ist, die Kondensatorkapazität können beispielsweise durch eine jeweilige Messung oder mehrere Messungen ermittelt werden, beispielsweise anhand eines jeweiligen Spannungseinbruchs bei einer hohen Strombelastung oder auf andere Weise.

Durch die Einstellung einer etwas geringeren Sendeleistung bei oben genannten Bedingungen sinkt der Strombedarf, d. h. der elektrische Energiebedarf, deutlich, so dass ein Datentelegramm trotz schwacher Batterie 3 und geringer Kondensatorkapazität des Kondensators 4 noch vollständig gesendet werden kann. Ein Abbrechen der Funkaussendung würde in allen Fällen den Verlust der Daten am Empfänger bedeuten. Die Aussendung mit geringerer Sendeleistung ist normalerweise unproblematisch, beispielsweise würde lediglich bei Vorrichtungen 1, die schon vorher, d. h. schon vor der Reduzierung der Sendeleistung, mit niedrigem Pegel am Empfänger anlagen, der Empfang verhindert oder deutlich erschwert werden.

Durch die beschriebene Lösung wird eine Steigerung einer Produktqualität erreicht. Des Weiteren können die Überdimensionierung der Batterie 3 und/oder des Kondensators 4 und damit einhergehende Kosten reduziert werden. Zudem werden durch die beschrieben Lösung viele zufällige Faktoren, welche im Verlauf der Einsatzdauer einen negativen Einfluss auf den Batterieladezustand und/oder die Kondensatorkapazität haben, berücksichtigt, insbesondere aufgrund echter Messungen des Batterieladezustands und/oder der Kondensatorkapazität.

Die beschriebene Lösung ermöglicht es zudem, am Beginn der Einsatzdauer der Vorrichtung 1 die Sendeleistung zu erhöhen, um beispielsweise eine bessere, insbesondere schnellere, Inbetriebnahme bei einer Installation der Vorrichtung 1 in ein Funkkommunikationsnetzwerk zu erreichen und dadurch insbesondere eine schnellere Inbetriebnahme des gesamten Funkkommunikationsnetzwerks zu erreichen.

### BEZUGSZEICHENLISTE

- 1: Vorrichtung
- 2: Funkkommunikationseinheit
- 3: Batterie
- 4: Kondensator
- 5: Einheit
- 6: Gehäuse

## Patentansprüche

1. Vorrichtung (1) mit einer Funkkommunikationseinheit (2) und einer Batterie (3) zur elektrischen Energieversorgung zumindest der Funkkommunikationseinheit (2), umfassend eine Einheit (5) zur Ermittlung oder Prognose eines aktuellen Batterieladezustandes und zur Einstellung einer Sendeleistung der Funkkommunikationseinheit (2) in Abhängigkeit vom ermittelten oder prognostizierten Batterieladezustand und in Abhängigkeit von einer verbleibenden vorgegebenen Einsatzdauer der Vorrichtung (1).

2. Vorrichtung (1) nach Anspruch 1,
umfassend einen Kondensator (4) zur elektrischen Energieversorgung zumindest der Funkkommunikationseinheit (2).

3. Vorrichtung (1) nach Anspruch 2,
wobei die Einheit (5) vorgesehen ist zur Ermittlung oder Prognose des aktuellen Batterieladezustandes und einer aktuellen Kondensatorkapazität und zur Einstellung der Sendeleistung der Funkkommunikationseinheit (2) in Abhängigkeit vom ermittelten oder prognostizierten Batterieladezustand und der ermittelten oder prognostizierten Kondensatorkapazität und in Abhängigkeit von der verbleibenden vorgegebenen Einsatzdauer der Vorrichtung (1).

4. Vorrichtung (1) nach einem der vorhergehenden Ansprüche,
umfassend eine Temperaturermittlungseinheit zur Ermittlung der Umgebungstemperatur.

5. Vorrichtung nach einem der vorhergehenden Ansprüche,
wobei die Einheit (5) vorgesehen ist zur Einstellung der Sendeleistung der Funkkommunikationseinheit (2) zusätzlich in Abhängigkeit von der Umgebungstemperatur.

6. Vorrichtung (1) nach einem der Ansprüche 2 bis 5,
wobei der Kondensator (4) als ein von der Batterie (3) ladbarer oder geladener Zwischenspeicherkondensator zur Zwischenspeicherung elektrischer Energie zumindest für die Funkkommunikationseinheit (2) ausgebildet ist.

7. Vorrichtung (1) nach einem der vorhergehenden Ansprüche,
ausgebildet als eine Verbrauchswerterfassungseinheit oder als ein Verbrauchsdatensammler.

8. Vorrichtung (1) nach Anspruch 7,
ausgebildet als ein elektronischer Heizkostenverteiler, Wasserzähler, Wärmezähler, Stromzähler oder Gaszähler.

9. Verfahren zur Einstellung einer Sendeleistung einer Funkkommunikationseinheit (2) einer Vorrichtung (1), insbesondere einer Vorrichtung (1) nach einem der vorhergehenden Ansprüche, wobei während einer vorgegebenen Einsatzdauer der Vorrichtung (1) mindestens einmal ein aktueller Batterieladezustand einer Batterie (3) ermittelt oder prognostiziert wird und die Sendeleistung der Funkkommunikationseinheit (2) in Abhängigkeit vom ermittelten oder prognostizierten Batterieladezustand und in Abhängigkeit von einer verbleibenden vorgegebenen Einsatzdauer eingestellt wird.

10. Verfahren nach Anspruch 9,
wobei während der vorgegebenen Einsatzdauer der Vorrichtung (1) mindestens einmal der aktuelle Batterieladezustand der Batterie (3) und eine aktuelle Kondensatorkapazität eines Kondensators (4) ermittelt oder prognostiziert wird und die Sendeleistung der Funkkommunikationseinheit (2) in Abhängigkeit vom ermittelten oder prognostizierten Batterieladezustand und von der ermittelten oder prognostizierten Kondensatorkapazität und in Abhängigkeit von einer verbleibenden vorgegebenen Einsatzdauer eingestellt wird.

11. Verfahren nach Anspruch 9 oder 10,
**dadurch gekennzeichnet, dass** die Sendeleistung der Funkkommunikationseinheit (2) zusätzlich in Abhängigkeit von der Umgebungstemperatur eingestellt wird.

12. Verfahren nach einem der Ansprüche 9 bis 11,
wobei der Kondensator (4) von der Batterie (3) geladen wird, die elektrische Energie zwischenspeichert und zumindest die Funkkommunikationseinheit (2) mit der zwischengespeicherten elektrischen Energie versorgt.
